# EUROPÄISCHE PATENTSCHRIFT

(11) **EP 3 840 553 B1**
(45) Veröffentlichungstag und Bekanntmachung des Hinweises auf die Patenterteilung: **03.01.2024**
(21) Anmeldenummer: 20213653.7
(22) Anmeldetag: 14.12.2020
(51) Int. Cl.: H05K 7/14

(54) **STROMRICHTEREINRICHTUNG UND ANTRIEBSEINRICHTUNG FÜR EIN ELEKTRISCH ANTREIBBARES FAHRZEUG**
POWER CONVERTER DEVICE AND DRIVING DEVICE FOR AN ELECTRICALLY DRIVEN VEHICLE
DISPOSITIF CONVERTISSEUR ET DISPOSITIF D'ENTRAÎNEMENT POUR UN VÉHICULE ÉLECTRIQUE

(30) Priorität: 17.12.2019 DE 102019134790
(43) Veröffentlichungstag der Anmeldung: 23.06.2021
(73) Patentinhaber: Valeo eAutomotive Germany GmbH, 91056 Erlangen (DE)
(72) Erfinder: SCHNEIDER, Guido, 97792 Riedenberg (DE)

(56) Entgegenhaltungen:
- EP-B1- 2 174 388
- CN-A- 110 476 305
- JP-A- 2017 098 193
- US-A1- 2013 237 068
- US-A1- 2016 352 215

## Beschreibung

Die vorliegende Erfindung betrifft eine Stromrichtereinrichtung, umfassend ein Stromrichtergehäuse mit einem Aufnahmeraum für elektrische Komponenten der Stromrichtereinrichtung und einer Abdeckung für den Aufnahmeraum, einen ersten Steckverbinder, der im Aufnahmeraum befestigt oder befestigbar ist, und einen zweiten Steckverbinder, der an der Abdeckung befestigt ist und dazu eingerichtet ist, eine elektrisch leitende Verbindung mit dem ersten Steckverbinder in einer ersten Stellung der Abdeckung, in welcher die Abdeckung den Aufnahmeraum verdeckt, auszubilden und die elektrisch leitende Verbindung zu unterbrechen, wenn die Abdeckung aus der ersten Stellung in eine zweite Stellung überführt wird, in der ein Zugriff auf den Aufnahmeraum möglich ist.

Daneben betrifft die Erfindung eine Antriebseinrichtung für ein elektrisch antreibbares Fahrzeug.

Bei derartigen, grundsätzlich nach dem Stand der Technik bekannten Stromrichtereinrichtung bilden die Steckverbinder typischerweise einen Teil einer Interlockschaltung, durch die ein Entfernen der Abdeckung vom Aufnahmeraum detektierbar ist. Dazu wird überprüft, ob die durch den ersten und zweiten Steckverbinder in der ersten Stellung hergestellte elektrische Verbindung unterbrochen wird, um daraus auf ein Entfernen der Abdeckung vom Aufnahmeraum zu schließen und die elektrischen Komponenten spannungsfrei zu schalten.

US 2016/352215 A1 offenbart einen Leistungswandler, aufweisend einen Gehäusekörper mit einem Gerätehauptkörper, in dem ein Leistungswandlungsteil aufgenommen ist und der eine Öffnung aufweist, eine Abdeckung, welche die Öffnung abdeckt, ein an dem Gehäusekörper befestigtes erstes Substrat und ein an der Abdeckung befestigtes zweites Substrat. Ein Verbindungsteil ist lösbar am ersten und zweiten Substrat befestigt, um das erste und zweite Substrat elektrisch zu verbinden.

US 2013/237068 A1 offenbart eine elektrische Anschlussbox, bei der ein erstes Gehäuse und ein zweites Gehäuse durch eine Rastverbindung aneinander befestigt sind.

Ein weiterer Leistungswandler ist aus CN 110 476 305 A bekannt.

Es ist ferner bekannt, den ersten Steckverbinder mittels einer Schraubverbindung im Aufnahmeraum zu befestigen. Nachteilig an einer solchen Lösung ist jedoch, dass die Montage des ersten Steckverbinders sehr aufwendig ist und zudem eine Fehlerquelle bietet, weil eine Schraube während der Montage, beispielsweise durch ein Missgeschick eines Monteurs, in die Stromrichtereinrichtung fallen kann und aus ihr aufwendig entfernt werden muss.

Der Erfindung liegt die Aufgabe zugrunde, eine montagefreundliche Möglichkeit zur Realisierung einer Interlockfunktion für eine Stromrichtereinrichtung anzugeben.

Zur Lösung dieser Aufgabe ist erfindungsgemäß eine Stromrichtereinrichtung nach Anspruch 1 vorgesehen.

Die Erfindung beruht auf der Überlegung, den ersten Steckverbinder mittels der Rastverbindung, also durch einen formschlüssigen Eingriff des ersten Steckverbinders mit der stromrichtergehäuseseitigen Rastvorrichtung, auszubilden, um so das aufwendige Herstellen einer Schraubverbindung zwischen dem ersten Steckverbinder und dem Stromrichtergehäuses zu vermeiden. Dadurch kann der erste Steckverbinder vorteilhafterweise in einem Arbeitsschritt montiert werden, ohne dass dabei die Gefahr besteht, dass Schrauben durch ein Missgeschick eines Monteurs in die Stromrichtereinrichtung fallen können. Mit zusätzlichem Vorteil wird gleichsam eine vereinfachte Demontierbarkeit, beispielsweise für den Fall einer Wartung oder einer Reparatur, des ersten Steckverbinders realisiert.

Zweckmäßigerweise ist bei der erfindungsgemäßen Stromrichtereinrichtung vorgesehen, dass diese eine Interlockschaltung mit einer Steuereinheit aufweist, mittels welcher eine Unterbrechung der elektrisch leitenden Verbindung des ersten Steckverbinders und des zweiten Steckverbinders detektierbar ist, wobei die Interlockschaltung dazu eingerichtet ist, bei einer Detektion der Unterbrechung die elektrischen Komponenten spannungsfrei zu schalten. Typischerweise weist der zweite Steckverbinder eine Brücke auf, welche die elektrisch leitende Verbindung in der ersten Stellung realisiert und in der zweiten Stellung Kontaktelemente des ersten Steckverbinders im Leerlauf belässt.

Bevorzugt ist bei der erfindungsgemäßen Stromrichtereinrichtung vorgesehen, dass die Rastvorrichtung in einem eingerasteten Zustand eine Bewegung des ersten Steckverbinders entlang einer ersten Raumrichtung hemmt.

Die Rastvorrichtung kann eine Ausnehmung aufweisen, in welcher ein Vorsprung des ersten Steckverbinders im eingerasteten Zustand eingreift. Dabei ist es zweckmäßig, wenn die Ausnehmung einen die Bewegung entlang der ersten Raumrichtungen hemmenden Anschlag für den Vorsprung ausbildet.

Es wird besonders bevorzugt, wenn der Vorsprung und die Ausnehmung eine Verdrehsicherung für den ersten Steckverbinder ausbilden. Die Verdrehsicherung ist typischerweise dazu eingerichtet, ein Einführen des Vorsprungs in die Ausnehmung in einer ersten Drehposition bezüglich einer senkrecht zur ersten Raumrichtungen verlaufenden Drehachse zu erlauben und das Einführen in einer um 180° bezüglich der Drehachse gedrehten zweiten Drehstellung zu verhindern. Dazu kann der Vorsprung einen vorstehenden Abschnitt aufweisen und die Rastvorrichtung eine Eintiefung aufweisen. Alternativ kann vorgesehen sein, dass der Vorsprung eine Eintiefung aufweist und die Rastvorrichtung einen vorstehenden Abschnitt aufweist.

In vorteilhafter Ausgestaltung kann ferner vorgesehen sein, dass die Rastvorrichtung den ersten Steckverbinder im eingerasteten Zustand an zwei gegenüberliegenden Seiten derart umgibt, dass die Rastvorrichtung eine Bewegung des ersten Steckverbinders entlang einer zur ersten Raumrichtung senkrechten zweiten Raumrichtung hemmt. Die zweite Raumrichtung ist typischerweise von einem Boden des Aufnahmeraums zu einer durch die Abdeckung in der ersten Stellung verschlossenen Öffnung des Aufnahmeraums hin gerichtet.

Dabei kann ferner vorgesehen sein, dass die Rastvorrichtung den ersten Steckverbinder in eingerasteten Zustand derart umgibt, dass sie eine Bewegung des ersten Steckverbinders in einer zur ersten Raumrichtung und zur zweiten Raumrichtung senkrechten dritten Raumrichtung hemmt. So kann die Position des ersten Steckverbinders vorteilhafterweise in allen drei translatorischen Freiheitsgraden festgelegt werden. Es hat sich bewährt, wenn die zweite Rastvorrichtung abgerundete Rastelemente aufweist, welche die erste Rastvorrichtung in der dritten Raumrichtung einfassen.

Hinsichtlich der mechanischen Befestigung der Rastvorrichtung wird es bevorzugt, wenn diese auf einem oder zwei Vorsprüngen eines Gehäusekörpers des Stromrichtergehäuses befestigt ist. Dazu können beispielsweise bereits bei einer herkömmlichen Stromrichtereinrichtung vorgesehene Vorsprünge mit einem Gewinde für eine Schraubverbindung verwendet werden, sodass sich die erfindungsgemäße Befestigung durch eine Rastvorrichtung ohne nennenswerte konstruktive Umgestaltungen am Gehäusekörper realisieren lässt.

Typischerweise ist die Rastvorrichtung aus einem Kunststoff gebildet. Alternativ oder zusätzlich kann vorgesehen sein, dass der Gehäusekörper aus einem Metall gebildet ist. Typischerweise ist der Gehäusekörper samt Vorsprung bzw. Vorsprüngen als Gussteil ausgebildet.

Es wird bei der erfindungsgemäßen Stromrichtereinrichtung bevorzugt, wenn der erste Steckverbinder zwei, insbesondere entlang der ersten Raumrichtung, gegenüberliegende Rastelemente aufweist. Typischerweise ist ein jeweiliges Rastelement durch eine, insbesondere nach außen weisende, Rastnase ausgebildet.

In bevorzugter Ausgestaltung der erfindungsgemäßen Stromrichtereinrichtung ist ferner vorgesehen, dass die Rastelemente zum Eingriff mit der Rastvorrichtung elastisch verformbar sind. Dabei wird es besonders bevorzugt, wenn der erste Steckverbinder zu einer Öffnung des Aufnahmeraums hin weisende Betätigungselemente aufweist, welche zum Herstellen der Rastverbindung und/oder zum Lösen der Rastverbindung manuell betätigbar sind. Typischerweise ist die Elastizität der Rastelemente höher als jene der stromrichtergehäuseseitigen Rastvorrichtung. Es kann vorgesehen sein, dass die Betätigungselemente im eingerasteten Zustand die stromrichtergehäuseseitige Rastvorrichtung zur Öffnung des Aufnahmeraums hin überragen.

Erfindungsgemäß ist vorgesehen, dass der erste Steckverbinder ein Betätigungselement oder mehrere Betätigungselemente zum Lösen der Rastverbindung umfasst. Dabei ist der zweite Steckverbinder dazu ausgebildet, eine Betätigung des oder eines jeweiligen Betätigungselements zum Lösen der Rastverbindung in einem miteinander verbunden Zustand des ersten Steckverbinders und des zweiten Steckverbinders zu hemmen. Dadurch kann verhindert werden, dass im miteinander verbundenen Zustand, also insbesondere wenn sich die Abdeckung in der ersten Stellung befindet, die Rastverbindung zwischen dem ersten Steckverbinder und dem Stromrichtergehäuse gelöst wird. Dies ist beispielsweise für einen Fall relevant, in dem eine Kraft zum Lösen der Steckverbinder größer als eine Kraft zum Lösen der Rastverbindung ist, beispielsweise wenn die Steckverbinder durch Korrosion aneinander hängen. Bevorzugt weist der zweite Steckverbinder für das oder ein jeweiliges Betätigungselement eine Anschlagsfläche auf, welche derart ausgebildet ist, dass die Anschlagsfläche einen Bewegungsweg des Betätigungselements zum Lösen der Rastverbindung dadurch begrenzt, dass das Betätigungselement vor einem Lösen der Rastverbindung an die Anschlagsfläche anschlägt.

In bevorzugter Ausgestaltung der erfindungsgemäßen Stromrichtereinrichtung ist vorgesehen, dass die elektrischen Komponenten elektrische Verbindungsmittel eines Wechselspannungsausgangs der Stromrichtereinrichtung sind. Die Stromrichtereinrichtung kann beispielsweise die Funktion eines Wechselrichters realisieren.

Typischerweise weist das Stromrichtergehäuse einen weiteren Aufnahmeraum auf, in welchem Halbleiterschaltungselemente angeordnet sind. Der weitere Aufnahmeraum wird typischerweise nicht durch die Abdeckung des ersten Aufnahmeraums in der ersten Stellung verdeckt. Im weiteren Aufnahmeraum können Halbleiterschalter der Stromrichtereinrichtung angeordnet sein.

Die der Erfindung zugrunde liegende Aufgabe wird ferner gelöst durch eine Antriebseinrichtung für ein elektrisch antreibbares Fahrzeug, umfassend eine elektrische Maschine, die zum Antreiben des Fahrzeugs eingerichtet ist, und eine erfindungsgemäße Stromrichtereinrichtung, wobei die Stromrichtereinrichtung zur Bereitstellung einer Wechselspannung für die elektrische Maschine eingerichtet ist.

Dabei wird es bevorzugt, wenn das Stromrichtergehäuse Teil eines die Stromrichtereinrichtung und die elektrische Maschine einhausenden Gehäuses ist.

Dazu kann das Stromrichtergehäuse eine Durchgangsöffnung zu einem die elektrische Maschine einhausenden Maschinengehäuse aufweisen.

Weitere Vorteile und Einzelheiten der vorliegenden Erfindung ergeben sich aus den im folgenden beschriebenen Ausführungsbeispielen sowie anhand der Zeichnungen. Diese sind schematische Darstellungen und zeigen:
- Fig. 1: eine geschnittene Detailansicht eines ersten Ausführungsbeispiels der erfindungsgemäßen Stromrichtereinrichtung;
- Fig. 2: eine weitere geschnittene Detailansicht der Stromrichtereinrichtung gemäß dem ersten Ausführungsbeispiel beim Einsetzen des ersten Steckverbinders;
- Fig. 3: eine Draufsicht auf die Rastvorrichtung gemäß dem ersten Ausführungsbeispiel;
- Fig. 4: eine perspektivische Ansicht der Rastvorrichtung gemäß dem ersten Ausführungsbeispiel;
- Fig. 5: eine perspektivische Ansicht eines zweiten Ausführungsbeispiels der erfindungsgemäßen Stromrichtereinrichtung im Vergleich zum ersten Ausführungsbeispiel;
- Fig. 6: eine perspektivische Ansicht eines dritten Ausführungsbeispiels der erfindungsgemäßen Stromrichtereinrichtung; und
- Fig. 7: eine Prinzipskizze eines Ausführungsbeispiel der erfindungsgemäßen Antriebseinrichtung.

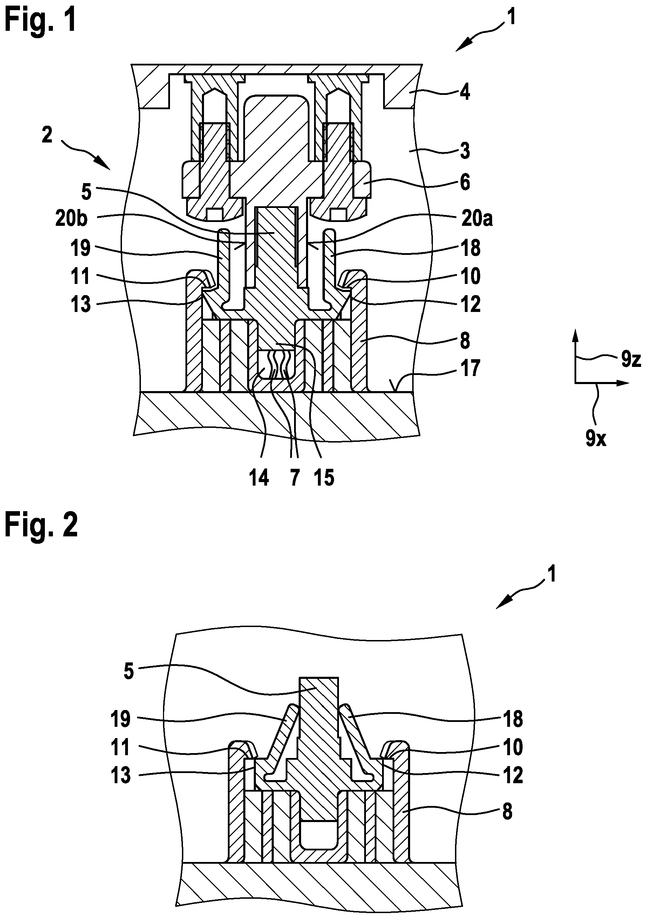

Fig. 1 ist eine geschnittene Detailansicht eines ersten Ausführungsbeispiels einer Stromrichtereinrichtung 1.

Die Stromrichtereinrichtung 1 umfasst ein Stromrichtergehäuses 2 mit einem Aufnahmeraum 3 für elektrische Komponenten (nicht gezeigt) der Stromrichtereinrichtung 1 und mit einer Abdeckung 4 für den Aufnahmeraum. Im vorliegenden Ausführungsbeispiel ist der Aufnahmeraum 3 wannenartig ausgebildet, sodass er durch die als Deckel ausgebildete Abdeckung 4 verschließbar ist.

Die Stromrichtereinrichtung 1 umfasst ferner einen ersten Steckverbinder 5, der im Aufnahmeraum 3 befestigt ist, und einen zweiten Steckverbinder 6, der an der Abdeckung 4 befestigt ist. Der zweite Steckverbinder 6 ist dazu eingerichtet, in einer ersten Stellung, die in Fig. 1 gezeigt ist, eine elektrisch leitende Verbindung mit dem ersten Steckverbinder 5 auszubilden und die elektrisch leitende Verbindung zu unterbrechen, wenn die Abdeckung 4 aus der ersten Stellung in eine zweite Stellung überführt wird, in der ein Zugriff auf den Aufnahmeraum 3 möglich ist.

Die Steckverbinder 5, 6 sind dabei Teil einer Interlockschaltung der Stromrichtereinrichtung 1, die dazu eingerichtet ist, die im Aufnahmeraum 3 angeordneten elektrischen Komponenten spannungsfrei zu schalten, wenn eine Steuereinrichtung der Interlockschaltung die Unterbrechung der elektrisch leitenden Verbindung detektiert. Dazu sind zwei Leitungen 7, die zur Steuereinheit führen, mit dem ersten Steckverbinder 5 verbunden, welcher zwei mit den Leitungen 7 verbundene Kontaktelemente aufweist. Der zweite Steckverbinder 6 umfasst eine Brücke, welche die Leitungen 7 in der ersten Stellung kurzschließt und die Kontaktelemente in der zweiten Stellung im Leerlauf belässt.

Das Stromrichtergehäuse 2 umfasst eine Rastvorrichtung 8 zur Befestigung des ersten Steckverbinders 5 mittels einer Rastverbindung im Stromrichtergehäuse 2. Im in Fig. 1 gezeigten eingerasteten Zustand hemmt die Rastverbindung 8 eine Bewegung des ersten Steckverbinders 5 entlang einer ersten Raumrichtung 9x und einer dazu senkrechten zweiten Raumrichtung 9z, wobei die zweite Raumrichtung 9z dabei von einem Boden 17 des Aufnahmeraums 3 zur Abdeckung 4 hin gerichtet ist. Dazu weist die Rastvorrichtung 8 Rastelemente 10, 11 auf, die im eingerasteten Zustand in Eingriff mit korrespondierenden Rastelementen 12, 13 des ersten Steckverbinders 5 sind. Die Rastelemente 10, 11 sind dabei als nach innen weisende Rastnasen und die Rastelemente 12, 13 als nach außen weisende Rastnasen ausgebildet. Die Rastvorrichtung 8 umfasst ferner eine Ausnehmung, in welche ein Vorsprung 15 des ersten Steckverbinders 5 im eingerasteten Zustand eingreift und einen die Bewegung entlang der ersten Raumrichtungen 9x hemmenden Anschlag für den Vorsprung 15 ausbildet.

Fig. 1 ist weiterhin zu entnehmen, dass der erste Steckverbinder 5 zwei als Hebel wirkende Betätigungselemente 18, 19 aufweist, welche die Rastvorrichtung 8 in der zweiten Raumrichtung 9z überragen. In einem Zustand, in dem die Steckverbinder 5, 6 nicht miteinander verbunden sind, sind die Betätigungselemente 18, 19 sind zum Lösen der Rastverbindung betätigbar und erleichtern die elastische Verformung der Rastelement 12, 13. In einem in Fig. 1 gezeigten miteinander verbundenen Zustand, also insbesondere in der ersten Stellung der Abdeckung 4, hemmt der zweite Steckverbinder 6 eine Betätigung der Betätigungselemente 18, 19. Dazu weist der zweite Steckverbinder 6 eine erste Anschlagsfläche 20a für das Betätigungselement 18 und eine zweite Anschlagsfläche 20b für das Betätigungselement 19 auf. Die Anschlagsflächen 20a, 20b begrenzen dabei einen Bewegungsweg der Betätigungselemente 18, 19 zum Lösen der Rastverbindung dadurch, dass die Betätigungselemente 18, 19 vor einem Lösen der Rastverbindung an die Anschlagsflächen 20a, 20b anschlagen.

Fig. 2 ist eine weitere geschnittene Detailansicht der Stromrichtereinrichtung 1 gemäß dem ersten Ausführungsbeispiel beim Einsetzen des ersten Steckverbinders 5 in die Rastvorrichtung 8.

Ersichtlich sind die Rastelemente 12, 13 des ersten Steckverbinders 5 elastisch verformbar, um einen Eingriff mit der Rastvorrichtung 8 herzustellen. Durch Betätigen der Betätigungselemente 18, 19 können die Rastelemente 12, 13 derart verformt werden, dass sie zwischen den Rastelemente 10, 11 der Rastvorrichtung 8 in diese eingeführt werden oder der eingerastete Zustand zum Entfernen des ersten Steckverbinders 5 gelöst wird. Wie zuvor beschrieben können die Betätigungselemente 18, 19 nur in dem in Fig. 2 gezeigten nicht miteinander verbundenen Zustand der Steckverbinder 5, 6 vollständig entlang des zum Lösen der Rastverbindung vorgegebenen Betätigungswegs bewegt werden.

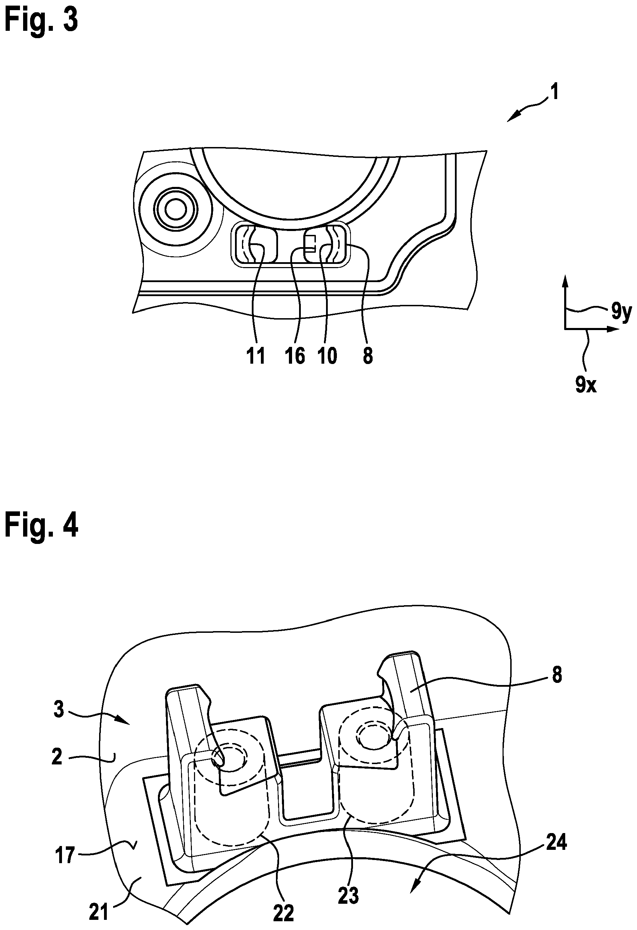

Fig. 3 ist eine Draufsicht auf die Rastvorrichtung 8.

Die Rastelemente 10, 11 der Rastvorrichtung 8 sind ersichtlich abgerundet ausgebildet, sodass sie eine Bewegung des ersten Steckverbinders 5 (siehe Fig. 1) im eingerasteten Zustand in einer zur ersten Raumrichtung 9x und zur zweiten Raumrichtung 9z senkrechten dritten Raumrichtung 9y hemmen, indem sie die Rastelemente 12, 13 in der dritten Raumrichtung 9y einfassen.

Optional kann eine gestrichelt angedeutete Verdrehsicherung 16 durch eine Eintiefung in der Rastvorrichtung 8 vorgesehen sein, welche es verhindert, dass der erste Steckverbinder 5, der dann einen mit der Ausnehmung korrespondieren vorstehenden Abschnitt aufweist, um 180° bezüglich der zweite Raumrichtung 9z verdreht in die Rastvorrichtung 8 eingesetzt wird. Alternativ kann zur Realisierung der Verdrehsicherung 16 in der Rastvorrichtung 8 ein vorstehender Abschnitt und im ersten Steckverbinder 5 eine korrespondierende Eintiefung vorgesehen sein.

Fig. 4 ist eine perspektivische Ansicht der Rastvorrichtung 8 gemäß dem ersten Ausführungsbeispiel.

Wie Fig. 4 zu entnehmen ist, weist das Stromrichtergehäuse 2 einen Gehäusekörper 21 mit zwei in den Aufnahmeraum 3 hinein weisenden Vorsprüngen 22, 23 auf. Der Gehäusekörper 21 und die Vorsprünge 22, 23 sind einstückig als Gussteil aus einem Metall gebildet. An den Vorsprüngen 22, 23 ist die aus einem Kunststoff gebildete Rastvorrichtung 8 befestigt. Fig. 4 zeigt ferner eine Durchgangsöffnung 24 im Boden 17 des Stromrichtergehäuses 2, auf welche später eingegangen wird.

Alternativ kann die Rastvorrichtung 8 mit dem Gehäusekörper 21 als ein Gussteil aus Metall ausgebildet sein und die Rastelemente 10, 11 der Rastvorrichtung 8 aus Fig. 3 beispielsweise mittels eines Tellerfräsers mechanisch bearbeitet werden.

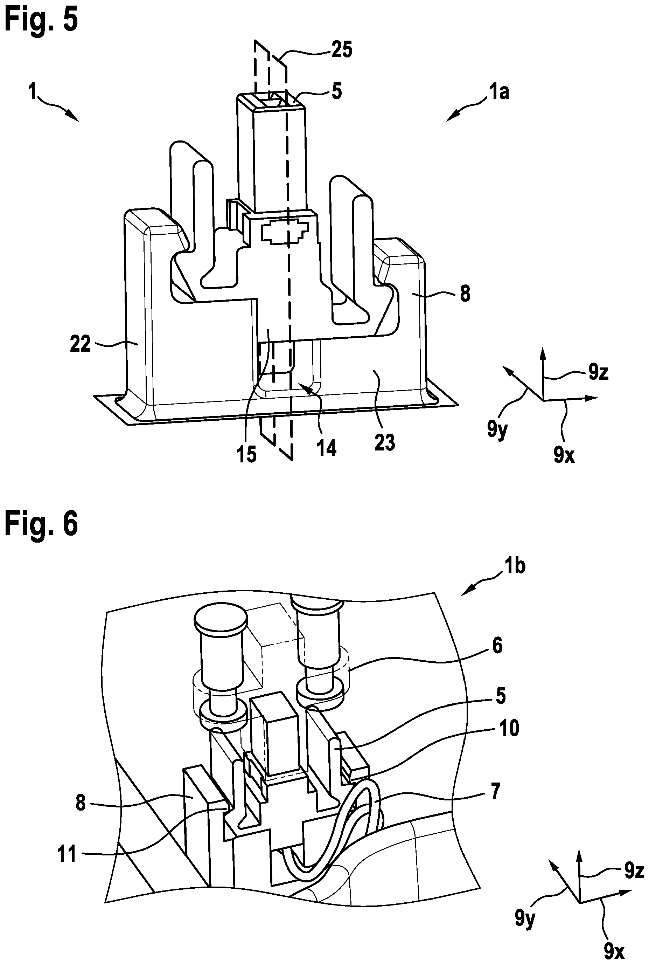

Fig. 5 ist eine perspektivische Ansicht des ersten Steckverbinders 5 und der Rastvorrichtung 8 gemäß einem zweiten Ausführungsbeispiel einer Stromrichtereinrichtung 1a im Vergleich zum ersten Ausführungsbeispiel der Stromrichtereinrichtung 1. Eine Trennungsebene 25, bezüglich derer die ersten Steckverbinder 5 und die Rastvorrichtungen 8 gemäß den beiden Ausführungsbeispielen symmetrisch sind, erleichtert dabei den Vergleich bei der Ausführungsbeispiele.

Der erste Steckverbinder 5 gemäß dem zweiten Ausführungsbeispiel weist ersichtlich keinen Vorsprung 15 auf, sondern überdeckt die Ausnehmung 14 der Rastvorrichtung 8. Ersichtlich können die Vorsprünge 23 beim zweiten Ausführungsbeispiel wesentlich niedriger bezüglich der zweiten Raumrichtung 9z ausgebildet werden, was deren Herstellung im Rahmen eines Gussverfahrens erheblich erleichtert.

Fig. 6 ist eine perspektivische Ansicht eines dritten Ausführungsbeispiels einer Stromrichtereinrichtung 1b, die bis auf die folgenden Abweichungen dem ersten Ausführungsbeispiel der Stromrichtereinrichtung 1 entspricht.

Ersichtlich sind die Rastelemente 10, 11 der Rastvorrichtung 8 hier gerade ausgebildet und ermöglichen so keine Hemmung der Bewegung des ersten Steckverbinders entlang der dritten Raumrichtung 9y, sind dafür jedoch einfacher zu fertigen.

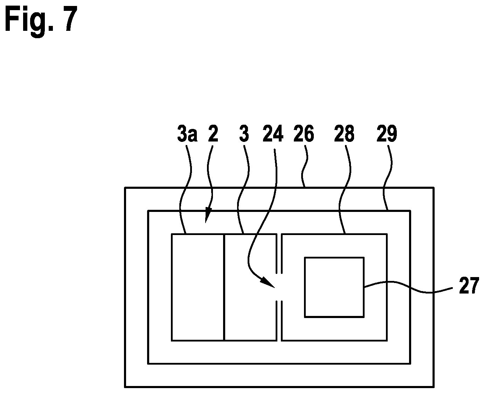

Fig. 7 ist eine Prinzipskizze eines Ausführungsbeispiels einer Antriebseinrichtung 26.

Diese umfasst eine elektrische Maschine 27, die zum Antreiben eines Fahrzeugs, beispielsweise eines Elektrofahrzeugs (BEV) oder eines Hybridfahrzeugs, eingerichtet ist, und eine Stromrichtereinrichtung 1 nach einem der zuvor beschrieben Ausführungsbeispiele. Das Stromrichtergehäuse 2 ist zusammen mit einem die elektrische Maschine 27 einhausenden Maschinengehäuses 28 Teil eines Gehäuses 29 der Antriebseinrichtung 26.

Das Stromrichtergehäuse 2 weist hier einen weiteren Aufnahmeraum 3a auf, in welchem elektrische Halbleiterschalter der Stromrichtereinrichtung 1 angeordnet sind und das nicht durch die Abdeckung 4 (siehe Fig. 1) abgedeckt wird. Die im Stromrichtergehäuse 2 aufgenommenen elektrische Komponenten sind Verbindungsmittel zwischen den Halbleiterschaltern und der elektrischen Maschine 27. Die Durchgangsöffnung 24 (siehe auch Fig. 4) erlaubt dabei eine Durchführung der Verbindungsmittel in das Maschinengehäuse 28. Das Stromrichtergehäuse 2 kann somit auch als Verbindungsbox erachtet werden.

## Patentansprüche

1. Stromrichtereinrichtung (1), umfassend
- ein Stromrichtergehäuse (2) mit einem Aufnahmeraum (3) für elektrische Komponenten der Stromrichtereinrichtung (1) und einer Abdeckung (4) für den Aufnahmeraum (3),
- einem ersten Steckverbinder (5), der im Aufnahmeraum (3) befestigt oder befestigbar ist, und
- einem zweiten Steckverbinder (6), der an der Abdeckung (4) befestigt ist und dazu eingerichtet ist, eine elektrisch leitende Verbindung mit dem ersten Steckverbinder (5) in einer ersten Stellung der Abdeckung (4), in welcher die Abdeckung (4) den Aufnahmeraum (3) verdeckt, auszubilden und die elektrisch leitende Verbindung zu unterbrechen, wenn die Abdeckung (4) aus der ersten Stellung in eine zweite Stellung überführt wird, in der ein Zugriff auf den Aufnahmeraum (3) möglich ist,
**dadurch gekennzeichnet, dass**
das Stromrichtergehäuse (2) eine Rastvorrichtung (8) zur Befestigung des ersten Steckverbinders (5) mittels einer Rastverbindung im Stromrichtergehäuse (2) aufweist, wobei der erste Steckverbinder (5) ein Betätigungselement oder mehrere Betätigungselemente (18, 19) zum Lösen der Rastverbindung umfasst, wobei der zweite Steckverbinder (6) dazu ausgebildet ist, eine Betätigung des oder eines jeweiligen Betätigungselements (18, 19) zum Lösen der Rastverbindung in einem miteinander verbunden Zustand des ersten Steckverbinders (5) und des zweiten Steckverbinders (6) zu hemmen.

2. Stromrichtereinrichtung nach Anspruch 1, wobei
die Rastvorrichtung (8) in einem eingerasteten Zustand eine Bewegung des ersten Steckverbinders (5) entlang einer ersten Raumrichtung (9x) hemmt.

3. Stromrichtereinrichtung nach Anspruch 2, wobei
die Rastvorrichtung (8) eine Ausnehmung (14) ausweist, in welche ein Vorsprung (15) des ersten Steckverbinders (5) im eingerasteten Zustand eingreift und einen die Bewegung entlang der ersten Raumrichtung (9x) hemmenden Anschlag für den Vorsprung (15) ausbildet.

4. Stromrichtereinrichtung nach Anspruch 3, wobei
der Vorsprung (15) und die Ausnehmung (14) eine Verdrehsicherung (16) für den ersten Steckverbinder (5) ausbilden.

5. Stromrichtereinrichtung nach Anspruch 2 bis 4, wobei
die Rastvorrichtung (8) den ersten Steckverbinder (5) im eingerasteten Zustand an zwei gegenüberliegenden Seiten derart umgibt, dass die Rastvorrichtung (8) eine Bewegung des ersten Steckverbinders (5) entlang einer zur ersten Raumrichtung (9x) senkrechten zweiten Raumrichtung (9z) hemmt.

6. Stromrichtereinrichtung nach Anspruch 5, wobei
die Rastvorrichtung (8) den ersten Steckverbinder (5) im eingerasteten Zustand derart umgibt, dass sie eine Bewegung des ersten Steckverbinders (5) in einer zur ersten Raumrichtung (9x) und zur zweiten Raumrichtung (9z) senkrechten dritten Raumrichtung (9y) hemmt.

7. Stromrichtereinrichtung nach Anspruch 6, wobei
die Rastvorrichtung (8) abgerundete Rastelemente (10, 11) aufweist, welche den ersten Steckverbinder (5) in der dritten Raumrichtung einfassen.

8. Stromrichtereinrichtung nach einem der vorhergehenden Ansprüche, wobei
die Rastvorrichtung (8) auf einem oder zwei Vorsprüngen (22, 23) eines Gehäusekörpers (21) des Stromrichtergehäuses (2) befestigt ist.

9. Stromrichtereinrichtung nach Anspruch 8, wobei
die Rastvorrichtung (8) aus einem Kunststoff gebildet ist und/oder der Gehäusekörper (21) aus einem Metall gebildet ist.

10. Stromrichtereinrichtung nach einem der vorhergehenden Ansprüche, wobei
der erste Steckverbinder (5) zwei gegenüberliegende Rastelemente (12, 13) aufweist.

11. Stromrichtereinrichtung nach Anspruch 10, wobei
die Rastelemente (12, 13) des ersten Steckverbinders zum Eingriff mit der Rastvorrichtung (8) elastisch verformbar sind.

12. Stromrichtereinrichtung nach einem der vorhergehenden Ansprüche, ferner umfassend
eine Interlockschaltung mit einer Steuereinheit, mittels welcher eine Unterbrechung der elektrisch leitenden Verbindung des ersten Steckverbinders (5) und des zweiten Steckverbinders (6) detektierbar ist, wobei die Interlockschaltung dazu eingerichtet ist, bei einer Detektion der Unterbrechung die elektrischen Komponenten spannungsfrei zu schalten.

13. Stromrichtereinrichtung nach einem der vorhergehenden Ansprüche, wobei
die elektrischen Komponenten elektrische Verbindungsmittel eines Wechselspannungsausgangs der Stromrichtereinrichtung (1) sind.

14. Antriebseinrichtung (26) für ein elektrisch antreibbares Fahrzeug, umfassend eine elektrische Maschine (27), die zum Antreiben des Fahrzeugs eingerichtet ist, und eine Stromrichtereinrichtung (1) nach einem der vorhergehenden Ansprüche, wobei die Stromrichtereinrichtung (1) zur Bereitstellung einer Wechselspannung für die elektrische Maschine (27) eingerichtet ist.

15. Antriebseinrichtung nach Anspruch 14, wobei
das Stromrichtergehäuse (2) Teil eines die Stromrichtereinrichtung (1) und die elektrische Maschine (27) einhausenden Gehäuses (29) ist.

## Claims

1. Power converter device (1), comprising
- a power converter housing (2) with a receiving space (3) for electrical components of the power converter device (1) and a cover (4) for the receiving space (3),
- a first plug-in connector (5), which is mounted or can be mounted in the receiving space (3), and
- a second plug-in connector (6), which is mounted on the cover (4) and is designed to form an electrically conductive connection with the first plug-in connector (5) in a first position of the cover (4), in which the cover (4) covers the receiving space (3), and to interrupt the electrically conductive connection when the cover (4) is moved from the first position to a second position, in which access to the receiving space (3) is possible,
**characterized in that**
the power converter housing (2) has a latching device (8) for mounting the first plug-in connector (5) by means of a latching connection in the power converter housing (2), wherein the first plug-in connector (5) comprises an operating element or several operating elements (18, 19) for releasing the latching connection, wherein the second plug-in connector (6) is designed to inhibit operation of the or a respective operating element (18, 19) for releasing the latching connection in a state in which the first plug-in connector (5) and the second plug-in connector (6) are connected to each other.

2. Power converter device according to Claim 1, wherein the latching device (8) inhibits a movement of the first plug-in connector (5) along a first spatial direction (9x) in a latched-in state.

3. Power converter device according to Claim 2, wherein the latching device (8) has a recess (14), into which a projection (15) of the first plug-in connector (5) engages in the latched-in state and which forms a stop, which inhibits the movement along the first spatial direction (9x), for the projection (15).

4. Power converter device according to Claim 3, wherein the projection (15) and the recess (14) form a rotation-prevention means (16) for the first plug-in connector (5) .

5. Power converter device according to Claims 2 to 4, wherein the latching device (8) surrounds the first plug-in connector (5) on two opposite sides in the latched-in state in such a way that the latching device (8) inhibits a movement of the first plug-in connector (5) along a second spatial direction (9z), which is perpendicular to the first spatial direction (9x).

6. Power converter device according to Claim 5, wherein the latching device (8) surrounds the first plug-in connector (5) in the latched-in state in such a way that it inhibits a movement of the first plug-in connector (5) in a third spatial direction (9y), which is perpendicular to the first spatial direction (9x) and the second spatial direction (9z).

7. Power converter device according to Claim 6, wherein the latching device (8) has rounded latching elements (10, 11) which border the first plug-in connector (5) in the third spatial direction.

8. Power converter device according to one of the preceding claims, wherein the latching device (8) is mounted on one or two projections (22, 23) of a housing body (21) of the power converter housing (2).

9. Power converter device according to Claim 8, wherein the latching device (8) is formed from a plastic and/or the housing body (21) is formed from a metal.

10. Power converter device according to one of the preceding claims, wherein
the first plug-in connector (5) has two opposite latching elements (12, 13).

11. Power converter device according to Claim 10, wherein
the latching elements (12, 13) of the first plug-in connector for engaging with the latching device (8) are elastically deformable.

12. Power converter device according to one of the preceding claims, further comprising
an interlock circuit with a control unit by means of which an interruption in the electrically conductive connection between the first plug-in connector (5) and the second plug-in connector (6) can be detected, wherein the interlock circuit is designed to isolate the electrical components when the interruption is detected.

13. Power converter device according to one of the preceding claims, wherein the electrical components are electrical connecting means of an AC voltage output of the power converter device (1).

14. Drive device (26) for an electrically driveable vehicle,
comprising an electrical machine (27), which is designed to drive the vehicle, and a power converter device (1) according to one of the preceding claims, wherein the power converter device (1) is designed to provide an AC voltage for the electrical machine (27).

15. Drive device according to Claim 14, wherein
the power converter housing (2) is part of a housing (29), which accommodates the power converter device (1) and the electrical machine (27).

## Revendications

1. Dispositif convertisseur de courant (1), ledit dispositif comprenant
- un boîtier convertisseur de courant (2) pourvu d'un espace de réception (3) destiné aux composants électriques du dispositif convertisseur de courant (1) et un couvercle (4) destiné à l'espace de réception (3),
- un premier connecteur enfichable (5) qui est fixé ou peut être fixé dans l'espace de réception (3), et
- un deuxième connecteur enfichable (6) qui est fixé au couvercle (4) et qui est conçu pour assurer une liaison électriquement conductrice avec le premier connecteur enfichable (5) dans une première position du couvercle (4) dans laquelle le couvercle (4) recouvre l'espace de réception (3) et pour interrompre la liaison électriquement conductrice lorsque le couvercle (4) est transféré de la première position à une deuxième position dans laquelle l'accès à l'espace de réception (3) est possible,
**caractérisé en ce que**
le boîtier convertisseur de courant (2) comporte un dispositif d'encliquetage (8) destiné à fixer le premier connecteur enfichable (5) dans le boîtier convertisseur de courant (2) au moyen d'une liaison à encliquetage, le premier connecteur enfichable (5) comprenant un ou plusieurs éléments d'actionnement (18, 19) destinés à libérer la liaison à encliquetage, le deuxième connecteur enfichable (6) étant conçu pour empêcher l'actionnement de l'élément ou d'un élément d'actionnement respectif (18, 19) afin de libérer la liaison à encliquetage lorsque le premier connecteur enfichable (5) et le deuxième connecteur enfichable (6) sont reliés l'un à l'autre.

2. Dispositif convertisseur de courant selon la revendication 1, dans lequel
le dispositif d'encliquetage (8) empêche le mouvement du premier connecteur enfichable (5) le long d'une première direction spatiale (9x) dans un état encliqueté.

3. Dispositif convertisseur de courant selon la revendication 2, dans lequel
le dispositif d'encliquetage (8) comporte un évidement (14) dans lequel une saillie (15) du premier connecteur enfichable (5) s'engage à l'état encliqueté et qui forme pour la saillie (15) une butée qui empêche le mouvement le long de la première direction spatiale (9x).

4. Dispositif convertisseur de courant selon la revendication 3, dans lequel
la saillie (15) et l'évidement (14) forme un moyen anti-rotation (16) destiné au premier connecteur enfichable (5) .

5. Dispositif convertisseur de courant selon les revendications 2 à 4, dans lequel
le dispositif d'encliquetage (8) entoure le premier connecteur enfichable (5) à l'état encliqueté sur deux côtés opposés de manière à ce que le dispositif d'encliquetage (8) empêche un mouvement du premier connecteur enfichable (5) le long d'une deuxième direction spatiale (9z) perpendiculaire à la première direction spatiale (9x).

6. Dispositif convertisseur de courant selon la revendication 5, dans lequel
le dispositif d'encliquetage (8) entoure le premier connecteur enfichable (5) à l'état encliqueté de manière à empêcher le mouvement du premier connecteur enfichable (5) dans une troisième direction spatiale (9y) perpendiculaire à la première direction spatiale (9x) et à la deuxième direction spatiale (9z).

7. Dispositif convertisseur de courant selon la revendication 6, dans lequel
le dispositif d'encliquetage (8) comporte des éléments d'encliquetage arrondis (10, 11) qui enserrent le premier connecteur enfichable (5) dans la troisième direction spatiale.

8. Dispositif convertisseur de courant selon l'une des revendications précédentes, dans lequel
le dispositif d'encliquetage (8) est fixé à une ou deux saillies (22, 23) d'un corps de boîtier (21) du boîtier convertisseur de courant (2).

9. Dispositif convertisseur de courant selon la revendication 8, dans lequel
le dispositif d'encliquetage (8) est en une matière synthétique et/ou le corps de boîtier (21) étant en un métal.

10. Dispositif convertisseur de courant selon l'une des revendications précédentes, dans lequel
le premier connecteur enfichable (5) comporte deux éléments d'encliquetage opposés (12, 13).

11. Dispositif convertisseur de courant selon la revendication 10, dans lequel
les éléments d'encliquetage (12, 13) du premier connecteur enfichable sont élastiquement déformables afin de s'engager avec le dispositif d'encliquetage (8).

12. Dispositif convertisseur de courant selon l'une des revendications précédentes, comprenant en outre
un circuit d'enclenchement pourvu d'une unité de commande, lequel permet d'interrompre la liaison électriquement conductrice du premier connecteur enfichable (5) et du deuxième connecteur enfichable (6), le circuit d'enclenchement étant conçu pour commuter les composants électriques lorsque l'interruption est détectée.

13. Dispositif convertisseur de courant selon l'une des revendications précédentes, dans lequel
les composants électriques sont des moyens de liaison électrique d'une sortie de tension alternative du dispositif convertisseur de courant (1).

14. Dispositif d'entraînement (26) destiné à un véhicule à propulsion électrique et comprenant une machine électrique (27) destinée à entraîner le véhicule, et un dispositif convertisseur de courant (1) selon l'une des revendications précédentes, dans lequel le dispositif convertisseur de courant (1) est conçu pour fournir une tension alternative à la machine électrique (27).

15. Dispositif d'entraînement selon la revendication 14, dans lequel le boîtier convertisseur de courant (2) fait partie d'un boîtier (29) abritant le dispositif convertisseur de courant (1) et la machine électrique (27) .
